# FASCICULE DE BREVET EUROPEEN

(11) **EP 2 191 536 B1**
(45) Date de publication et mention de la délivrance du brevet: **07.01.2015**
(21) Numéro de dépôt: 08803782.5
(22) Date de dépôt: 05.09.2008
(51) Int. Cl.: H01Q 1/32, E05B 81/78, E05B 77/34, H01Q 1/40, H05K 3/28, H05K 1/18

(54) **PROCEDE DE FABRICATION D'UN CAPTEUR D'APPROCHE.**
HERSTELLUNGSVERFAHREN FÜR EINEN ANNÄHERUNGSSENSOR.
METHOD OF MANUFACTURING AN APPROACH SENSOR.

(30) Priorité: 12.09.2007 FR 0706402
(43) Date de publication de la demande: 02.06.2010
(73) Titulaire: Valeo Comfort and Driving Assistance, 94046 Créteil Cedex (FR)
(72) Inventeur: DE POMMERY, Alain, F-94042 Creteil Cedex (FR); ETTER, Stephane, F-94042 Creteil Cedex (FR); AUBRY, Anthony, F-94042 Creteil Cedex (FR)
(74) Mandataire: Jacquot, Ludovic R. G.
(86) Numéro de dépôt international: PCT/EP2008/061813
(87) Numéro de publication internationale: WO 2009/034040

(56) Documents cités:
- EP-A- 1 369 546
- WO-A-03/029049
- WO-A-2004/091044
- WO-A-2005/029639
- FR-A- 2 892 566

## Description

La présente invention concerne un procédé de fabrication d'un capteur d'approche permettant de repérer la présence d'un utilisateur et destiné à être monté dans la poignée d'un ouvrant de véhicule automobile.

Ce procédé de fabrication permet d'assurer l'étanchéité du détecteur vis à vis des conditions environnementales extérieures.

Les systèmes d'ouverture de porte sans clé sont de plus en plus répandus dans l'industrie automobile. Dans ces systèmes, appelés « mains libres », la clé est remplacée par un identifiant matérialisé par un badge électronique.

Un capteur d'approche placé dans la poignée de l'ouvrant permet la détection de l'utilisateur et entraîne l'initiation de la communication entre l'identifiant et le système embarqué dans le véhicule afin de permettre le déverrouillage des portes. Afin de préserver ce capteur d'approche des conditions environnementales extérieures, en particulier de l'humidité, il doit être muni d'une protection étanche. Le capteur n'étant pas destiné à être immergé, une étanchéité basse pression, c'est à dire protégeant de l'humidité, des impuretés et de simples projections d'eau, suffit.

Par ailleurs, les poignées peuvent présenter différentes formes selon les modèles de véhicule et le capteur doit donc pouvoir s'adapter à chaque forme.

On connaît déjà une étanchéité réalisée directement dans la poignée. L'inconvénient de cette solution est qu'elle implique le développement de poignées adaptées pour chaque type de capteur et nécessite l'emploi de joints d'étanchéité. Ces derniers peuvent se dégrader au cours du temps ou subir des contraintes notamment en fonction de la température extérieure, ce qui peut entraîner une perte d'étanchéité et par conséquent l'endommagement du capteur.

Une autre solution consiste à utiliser un surmoulage plastique spécifique pour chaque poignée. Les moules utilisés pour cette technique sont onéreux et entraînent un coût de production élevé. Dans le document FR2892566, un module de transmission comprend une antenne consitutée d'un élément flexible enrobé dans une enveloppe en un matériau souple conférant des facultés de déformation au module de transmission. Ce module est adapté dans une poignée de portière de véhicule automobile.

Ainsi, la présente invention a pour but de résoudre les inconvénients précités de la technique en proposant un procédé de fabrication permettant de rendre le capteur étanche et facilement adaptable aux différentes formes de poignées, ceci pour un coût réduit.

A cet effet, l'invention concerne un procédé de fabrication d'un capteur d'approche étanche, destiné à être monté dans une poignée d'ouvrant de véhicule automobile, caractérisé en ce qu'il comporte les étapes suivantes, on place les composants électriques du capteur sur un circuit imprimé souple, on place ledit circuit imprimé de chant sur une première tranche longitudinale dans un moule incurvé et, on coule par gravité une résine sur la seconde tranche longitudinale de manière à enrober ledit capteur pour le rendre étanche.

D'autres caractéristiques et avantages de l'invention apparaîtront de la description qui va maintenant en être faite, en référence aux dessins annexés qui en représentent, à titre indicatif mais non limitatif, d'un mode de réalisation possible.
- La figure 1 représente un schéma d'un mode de réalisation d'un capteur d'approche étanche selon l'invention
- La figure 2 est une vue schématique en coupe longitudinale d'une poignée d'un ouvrant de véhicule automobile comportant un capteur d'approche étanche selon l'invention.

Les différentes étapes du procédé selon l'invention vont maintenant être décrites plus en détail en référence aux figures. Sur ces figures, les éléments identiques portent les mêmes numéros de référence.

La première étape consiste à positionner les composants électriques du capteur d'approche 1 sur un circuit imprimé souple 3. Ces composants comportent une antenne en ferrite 5, des électrodes de détection 7 d'un capteur d'approche dont une est dédiée à l'ouverture et l'autre à la fermeture des ouvrants, et des composants électroniques 9. Un câble 11 permet l'alimentation du capteur 1.

Dans la deuxième étape, on pose de chant le circuit imprimé souple 3 dans un moule incurvé ou dans un boîtier plastique. L'emploi d'un circuit imprimé souple 3 permet de s'adapter à la forme courbe du moule. La forme exacte du moule est définie en fonction des poignées d'ouvrant de véhicule auxquelles le capteur est destiné et permet ainsi une adaptation à la majorité des poignées.

Dans la troisième étape, on coule par gravité une résine sur la tranche longitudinale du capteur qui n'est pas en contact avec le moule. Le fait de positionner le capteur de chant permet de faciliter l'étalement de la résine autour du capteur. La gravité permet l'étalement de la résine autour du capteur de manière à ce que le circuit imprimé souple 3 et ses composants soient totalement recouvert de résine protectrice. La résine prend ainsi la même forme arrondie que le capteur et le moule.

La dernière étape consiste à sécher la résine. En séchant, cette dernière durcit et garde la forme imposée par le moule. On obtient ainsi un enrobage en résine 13 du capteur 1.

Ce procédé permet donc d'obtenir un capteur d'approche 1 étanche aux conditions environnementales extérieures et dont la forme incurvée permet une adaptation aux poignées d'ouvrants de véhicule automobile ayant une forme courbe. De plus, ce procédé est facile à réaliser et ne nécessite pas de gros investissements.

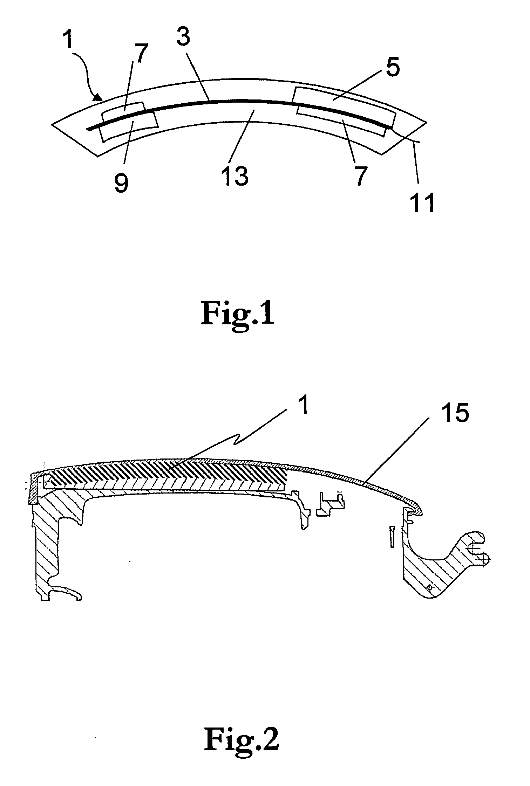

La figure 2 montre une vue schématique en coupe longitudinale d'une poignée 15 équipée d'un capteur selon l'invention.

## Revendications

1. Procédé de fabrication d'un capteur d'approche étanche (1), destiné à être monté dans une poignée d'ouvrant de véhicule automobile, **caractérisé en ce qu'**il comporte les étapes suivantes:
- on place les composants électriques du capteur sur un circuit imprimé souple (3),
- on place ledit circuit imprimé (3) de chant sur une première tranche longitudinale dans un moule incurvé et,
- on coule par gravité une résine (13) sur la seconde tranche longitudinale de manière à enrober ledit capteur pour le rendre étanche,
**caractérisé en ce qu'**il comporte également l'étape de sécher la résine afin d'obtenir un enrobage dur du capteur à la forme du moule incurvé.

2. Capteur d'approche étanche (1) fabriqué selon le procédé de la revendication 1 destiné à être monté dans une poignée d'un ouvrant de véhicule automobile comportant un circuit imprimé souple (3) enrobé d'une couche de résine (13) **caractérisé en ce que** la forme dudit capteur (1) est incurvée.

3. Poignée d'un ouvrant de véhicule automobile **caractérisée en ce qu'**elle comporte un capteur d'approche étanche (1) selon la revendication 2.

## Patentansprüche

1. Verfahren zur Herstellung eines dichten Annäherungssensors (1), der in einem Griff eines Öffnungsteils eines Kraftfahrzeugs angebracht werden soll, **dadurch gekennzeichnet, dass** es die folgenden Schritte umfasst:
- Platzieren der elektrischen Bauelemente des Sensors auf einer flexiblen Leiterplatte (3),
- Platzieren der Leiterplatte (3) hochkant auf einem ersten Längsrand in einem gekrümmten Formwerkzeug und
- Gießen eines Harzes (13) durch Schwerkraft auf den zweiten Längsrand, um den Sensor zu ummanteln und ihn somit abzudichten,
**dadurch gekennzeichnet, dass** es des Weiteren den Schritt des Trocknens des Harzes zum Erhalt eines harten Überzugs des Sensors gemäß der Form des gekrümmten Formwerkzeugs umfasst.

2. Nach dem Verfahren von Anspruch 1 hergestellter dichter Annäherungssensor (1), der in einem Griff eines Öffnungsteils eines Kraftfahrzeugs angebracht werden soll, mit einer flexiblen Leiterplatte (3), die mit einer Harzschicht (13) überzogen ist, **dadurch gekennzeichnet, dass** die Form des Sensors (1) gekrümmt ist.

3. Griff eines Öffnungsteils eines Kraftfahrzeugs, **dadurch gekennzeichnet, dass** er einen dichten Annäherungssensor (1) nach Anspruch 2 umfasst.

## Claims

1. Method of manufacturing a sealed approach sensor (1) intended to be mounted in a motor vehicle door handle, **characterized in that** it comprises the following steps:
- the electrical components of the sensor are placed on a flexible printed circuit (3),
- the said printed circuit (3) is placed edge-on on a first longitudinal edge in a curved mould, and
- a resin (13) is poured under gravity onto the second longitudinal edge in order to encapsulate the said sensor to render it sealed,
**characterized in that** it also comprises the step of drying the resin in order to obtain a hard encapsulation of the sensor in the shape of the curved mould.

2. Sealed approach sensor (1) manufactured using the method of Claim 1, intended to be mounted in a motor vehicle door handle comprising a flexible printed circuit (3) encapsulated in a layer of resin (13), **characterized in that** the shape of the said sensor (1) is curved.

3. Motor vehicle door handle, **characterized in that** it comprises a sealed approach sensor (1) according to Claim 2.
